# EUROPÄISCHE PATENTSCHRIFT

(11) **EP 1 060 504 B1**
(45) Veröffentlichungstag und Bekanntmachung des Hinweises auf die Patenterteilung: **19.06.2002**
(21) Anmeldenummer: 99915537.7
(22) Anmeldetag: 25.02.1999
(51) Int. Cl.: H01L 21/00

(54) **VORRICHTUNG FÜR EINE THERMISCHE BEHANDLUNG VON SUBSTRATEN**
DEVICE FOR THE THERMAL TREATMENT OF SUBSTRATES
DISPOSITIF DE TRAITEMENT THERMIQUE DE SUBSTRATS

(30) Priorität: 02.03.1998 DE 19808712; 08.02.1999 DE 19905050
(43) Veröffentlichungstag der Anmeldung: 20.12.2000
(73) Patentinhaber: STEAG RTP Systems GmbH, 89160 Dornstadt (DE)
(72) Erfinder: BLERSCH, Werner, D-88477 Bussmannshausen (DE); WALK, Heinrich, D-89604 Allmendingen (DE)
(74) Vertreter: Geyer, Ulrich F., Dr. Dipl.-Phys.
(86) Internationale Anmeldenummer: EP9901229
(87) Internationale Veröffentlichungsnummer: WO9945573

(56) Entgegenhaltungen:
- EP-A- 0 505 928
- US-A- 3 836 751
- US-A- 4 654 509
- US-A- 5 561 735

## Beschreibung

Die vorliegende Erfindung bezieht sich auf eine Vorrichtung für eine thermische Behandlung von Substraten, mit einer Reaktionskammer, wenigstens einer langgestreckten Heizquelle und wenigstens einer wenigstens eine Rippe aufweisenden, zur Heizquelle benachbarten Reflexionswand zur Reflexion wenigstens eines Teils einer von der Heizquelle abgestrahlten Strahlung.

Eine Vorrichtung dieser Art ist beispielsweise aus der JP 5-190558 A bekannt. Die Reflexionswände weisen sich parallel zu Heizlampen erstreckende Nuten auf, in denen die Heizlampen zumindest teilweise angeordnet sind und welche die wenigstens eine Rippe bilden. Bei dieser Art der Reflexionswand ergibt sich eine reflektierte Strahlung die parallel zu den Lampen ist. Derartige Vorrichtungen mit sich parallel zu den Heizlampen erstreckenden Konturen in einer Reflexionswand sind ferner aus JP 61-125021 A, sowie der JP 60-193343 A bekannt.

In der auf dieselbe Anmelderin zurückgehenden, nicht vorveröffentlichten DE 197 37 802 ist eine Vorrichtung für eine thermische Behandlung von Substraten beschrieben. Bei dieser Vorrichtung befindet sich eine Reaktionskammer aus Quarzglas innerhalb einer zweiten, größeren, Kammer mit Reflexionswänden. Oberhalb und unterhalb der Reaktionskammer sind Heizquellen in Form von Stablampen angeordnet um ein in der Reaktionskammer befindliches Substrat, insbesondere Halbleiterwafer, aufzuheizen. Die Reflexionswände der Vorrichtung sind eben, so daß sich wiederum eine reflektierte Strahlung parallel zu den Lampen ergibt.

Durch diese parallele Reflexion an der Reflexionswand ergibt sich innerhalb der Reaktionskammer eine bestimmte, periodische Intensitätsverteilung des einfallenden Lichtes zur Erwärmung des Substrats. Hierdurch kann das Substrat in Teilbereichen stärker erwärmt werden, als in anderen Teilbereichen, was jedoch nachteilig ist, da die Substrate möglichst gleichmäßig erwärmt werden müssen.

Ferner ist es aus der US-A-4,654,509 sowie der US-A-3,836,751 bekannt, bei einer Schnellheizanlage obere und untere Lampenbänke mit Stablampen derart anzuordnen, daß die Stablampen der oberen Lampenbank zu den Stablampen der unteren Lampenbank um 90° gedreht sind. Benachbart zu den Stablampen liegende Reflexionswände weisen jeweils sich parallel zu den Stablampen erstreckende Nuten auf, wodurch sich eine reflektierte Strahlung ergibt, die parallel zu den Lampen ist.

Die US-A-5,561,734 zeigt eine Vorrichtung zum thermischen Behandeln von Substraten bei der eine langgestreckte Heizguelle und eine Reflexipnswand mit Rippen vorgesehen sind. Die Rippen der Reflexionswand erstrecken sich parallel zu der Heizquelle.

Der Erfindung gemäß dem Anspruch 1 liegt daher die Aufgabe zugrunde, eine Vorrichtung für eine thermische Behandlung von Substraten der oben genannten Art zu schaffen, bei der eine gleichmäßigere Erwärmung der Substrate möglich ist.

Die der Erfindung zugrunde liegende Aufgabe wird dadurch gelöst, daß die Heizquelle(n) in einem Winkel schräg zur Längsrichtung der wenigstens einen Rippe angeordnet ist (sind). Durch diese Anordnung wird das Spiegelbild der Heizquellen in einem Maße, das vom Winkel zwischen den Röhren und den Rippen abhängt, gedreht, so daß sich eine gleichmäßiger gerichtete Verteilung der strahlungsintensität in der Reaktionskammer ergibt.

Gemäß einer bevorzugten Ausführungsform der Erfindung weist die Reflexionswand mehrere parallel zueinander angeordnete Rippen auf. Durch die Vielzahl von Rippen ergibt sich eine einfache Möglichkeit die Strahlungsintensität innerhalb der gesamten Reaktionskammer gleichmäßiger zu verteilen. Dabei werden die Rippen vorzugsweise durch Nuten gebildet.

Gemäß einer besonders bevorzugten Ausführungsform der Erfindung sind die Heizquellen Stablampen, die eine einfache und gut steuerbare Heizquelle vorsehen.

Vorzugsweise beträgt der Winkel zwischen den Rippen und den Heizquellen 45°, damit das Spiegelbild der Heizquellen in einem Winkel von 90° gedreht ist. Somit ergibt sich eine Reflexions-Strahlung, die senkrecht zu der direkten Strahlung der Lampenröhren verlauft, wodurch eine besonders gleichmäßige Strahlungsintensität innerhalb der Reaktionskammer erzeugt wird.

Gemäß einer Ausführungsform erstrecken sich die Rippen gleichmäßig über die ganze Reflexionswand hinweg, um über die gesamte Reflexionswand hinweg den oben genannten Effekt zu erzeugen.

Gemäß einer weiteren Ausführungsform erstrecken sich die Rippen wenigstens über Teilbereiche der Reflexionswand insbesondere in den Außenbereichen der Reflexionswand, um eine Reflexion der Wärmestrahlung in Richtung des zu erwärmenden Substrats zu ermöglichen.

Bei einer besonders vorteilhaften Ausgestaltung der Erfindung ist ferner wenigstens eine Drehvorrichtung zum Drehen der wenigstens eine Rippe aufweisenden Reflexionswand vorgesehen. Durch die Drehung ist es möglich, die Intensitätsverteilung des Strahlungsfeldes in einem Behandlungsraum den jeweiligen Prozeßbedingungen anzupassen. Insbesondere kann durch die Drehung der Reflexionswand über die Zeit hinweg die Intensitätsverteilung homogenisiert werden, wodurch ein gleichmäßigeres Aufheizen des Substrats ermöglicht wird. Ferner wird durch die Drehung der Reflexionswand die Intensitätsverteilung der Strahlung mit der Rotationsfrequenz der Reflexionswand moduliert. Eine Modulation läßt sich z. B. auch vorteilhaft zur Temperaturmessung mittels Pyrometrie verwenden.

Vorteilhafterweise ist eine Steuereinheit zur Steuerung der Drehvorrichtung vorgesehen, um die Drehung und somit die Intensitätsverteilung der Strahlung innerhalb eines Behandlungsraums an die jeweiligen Prozeßbedingungen und Prozeßschritte anzupassen.

Unter dem Begriff Substrate sind in diesem Zusammenhang Halbleiterwafer, Masken, Platten sowie alle Objekte zu verstehen, die oder deren Oberfläche einer thermischen Behandlung unterzogen werden.

Die Erfindung wird nachstehend anhand eines bevorzugten Ausführungsbeispiels unter Bezugnahme auf die Zeichnungen erläutert; in den Zeichnungen zeigt:
- Figur 1: eine schematische Querschnittsdarstellung einer Vorrichtung für eine thermische Behandlung von Substraten;
- Figur 2: eine perspektivische Ansicht einer erfindungsgemäßen Reflexionswand der Vorrichtung gemäß Figur 1; und
- Figur 3: eine perspektivische Ansicht der in Figur 2 dargestellten erfindungsgemäßen Reflexionswand mit darüber angeordneten Stablampen.

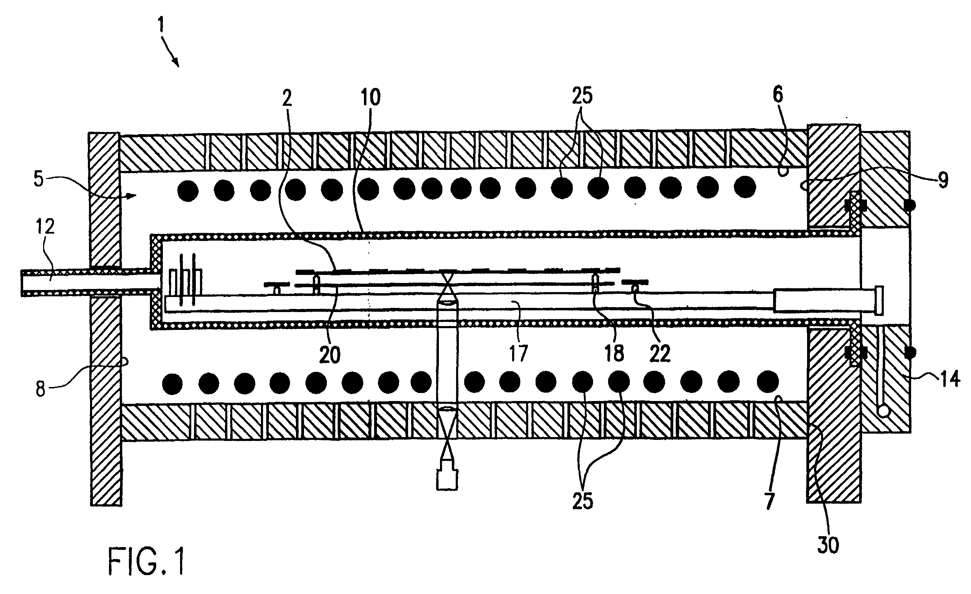

Figur 1 zeigt schematisch eine Vorrichtung 1 für eine thermische Behandlung von Substraten 2. Die Vorrichtung 1 weist eine erste, verspiegelte Kammer 5 mit einer oberen Reflektorwand 6, einer unteren Reflektorwand 7, reflektierenden Seitenwänden 8, 9 und nicht dargestellten vorderen und hinteren, reflektierenden Wänden auf. In der Kammer 5 ist eine Reaktionskammer 10, die vorzugsweise aus Quarzglas hergestellt ist, angeordnet. Die Reaktionskammer 10 weist ein Gaszuführungsrohr 12 zum Einleiten eines Reaktionsgases und einen Kammertürrahmen 14 zum Ein- und Ausbringen des Substrats 2, im vorliegenden Fall eines Halbleiterwafers, auf. Auf einem Quartz-Substratträger 17 befindet sich das von ihm durch Abstandshalter 18 beabstandete Substrat 2. Konzentrisch zum Substrat 2 ist ein Kompensationsring 22 vorgesehen mit dem eine bessere thermische Homogenität erreichbar ist.

Zwischen den Reflektorwänden 6, 7 und der Reaktionskammer sind jeweils Stablampen 25 angeordnet, die sich in paralleler Ausrichtung zu den Seitenwänden 8, 9 zwischen den nicht dargestellten vorderen und hinteren Wänden erstrecken. Der Aufbau einer derartigen Vorrichtung, sowie Einzelheiten bezüglich der Funktionsweisen derselben sind in der bereits erwähnten, auf dieselbe Anmelderin zurückgehende DE-A-44 37 361 sowie in der nicht vorveröffentlichten DE-A-197 37 802 beschrieben. Um Wiederholungen zu vermeiden, wird der Inhalt dieser Druckschriften insofern zum Gegenstand der vorliegenden Anmeldung gemacht.

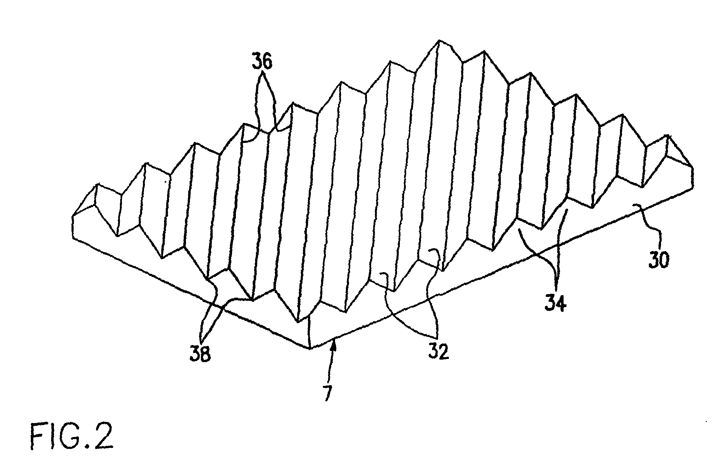

Während in Figur 1 die Kontur der Reflektorwände 6 und 7 nicht zu erkennen ist, zeigt Figur 2 ein Beispiel für die erfindungsgemäße Konturierung einer Reflektorwand, wobei die Konturierung nur anhand der unteren Reflektorwand 7 erläutert wird. Auf der zu der Reaktionskammer 10 weisenden Oberfläche der Refklektorwand 7 sind Nuten 32 in einem Winkel von 45° bezüglich einer Seitenfläche 30 ausgebildet. Die Nuten 32 besitzen eine Dreiecksform, derart, daß Rippen 34 mit einer nach oben spitz zulaufenden Kante 36 gebildet werden. Zwischen den nach oben spitz zulaufenden Seitenflächen der dreiecksförmigen Nuten 32 wird jeweils im tiefsten Punkt der Nuten 32 eine untere Nutkante 38 gebildet.

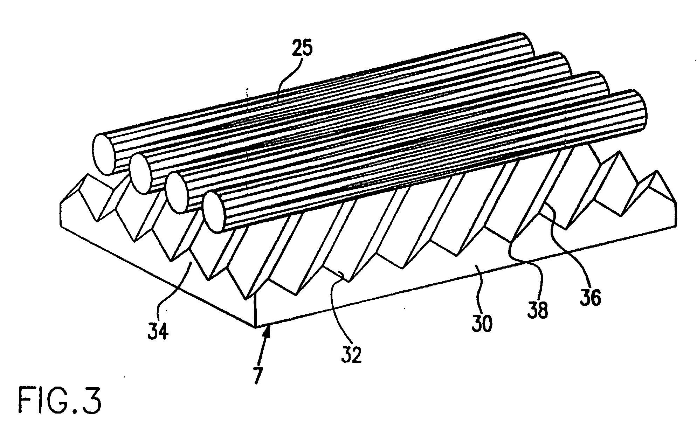

Wie in Figur 3 zu erkennen ist, erstrecken sich oberhalb der Reflektor- oder Reflexionswand 7 die Stablampen 25, und zwar in paralleler Ausrichtung zu der Seitenfläche 30, so daß sich die Rippen 34 in einem Winkel von 45° zu den Stablampen 25 erstrecken. Durch diese Anordnung wird - wie oben erwähnt - ein Spiegelbild der Stablampen 25 in einem um 90° gedrehten Winkel bezüglich der Stablampen 25 erzeugt.

Oberhalb der oberen Reflektorwand 6 ist eine nicht dargestellte Drehvorrichtung vorgesehen, die mit der Reflektorwand in Verbindung steht, um diese um eine senkrecht zu dem Substrat 2 verlaufende Achse zu drehen. Die Drehung erfolgt steuerbar mittels einer entsprechenden Steuervorrichtung und wird den jeweiligen Prozeßbedingungen und Prozeßschritten während der Wärmebehandlung eines Substrats angepaßt.

Ferner wird durch die Rotation der Reflexionswand die Intensitätsverteilung in der Kammer mit der Rotationsfrequenz der Reflexionswand moduliert. Diese Modulation kann bei einer Temperaturmessung mittels Pyrometrie verwendet werden. Ein Verfahren zur Messung der Substrattemperatur mittels aktiver Modulation der Lampenstrahlung ist beispielsweise in der auf die Anmelderin zurückgehenden, nicht vorveröffentlichten DE 198 55 683.7 beschrieben.

Die Erfindung wurde zuvor anhand eines bevorzugten Ausführungsbeispiels erläutert. Dem Fachmann sind jedoch Ausgestaltungen und Abwandlungen möglich, ohne daß dadurch der Erfindungsgedanke verlassen wird. Insbesondere sind auch andere Konturen der erfindungsgemäßen Reflexionswand als die dargestellten Rippen 34 möglich. Auch ist eine gleichmäßige Erstreckung der Konturen über die gesamte Reflexionswand hinweg nicht notwendig, und es könnten auch Bereiche an der Reflexionswand vorgesehen sein, in denen keine Konturen vorgesehen sind.

Auch der Aufbau der Vorrichtung 1 ist nicht auf den konkret beschriebenen beschränkt. So ist es zum Beispiel möglich, die oberhalb und unterhalb der Reaktionskammer angeordneten Stablampen um 90° zu versetzen, oder den Winkel zwischen den Rippen 34 und den Stablampen 25 kleiner oder größer als 45° zu wählen. Ferner ist es möglich, eine Bewegungseinrichtung, insbesondere eine Dreheinrichtung, vorzusehen, um das Substrat innerhalb der Reaktionskammer zu bewegen.

## Patentansprüche

1. Vorrichtung (1) für eine thermische Behandlung von Substraten(2), mit einer Reaktionskammer (10), wenigstens einer langgestreckten Heizquelle (25) und wenigstens einer wenigstens eine Rippe (34) aufweisenden, zur Heizquelle benachbarten Reflexionswand (6, 7) zur Reflexion wenigstens eines Teils einer von der Heizquelle (25) abgestrahlten Strahlung, **dadurch gekennzeichnet, daß** die Heizquellen (25), in einem Winkel schräg zur Längsrichtung der wenigstens einen Rippe (34) angeordnet sind.

2. Vorrichtung nach Anspruch 1, **gekennzeichnet durch** mehrere parallel zueinander angeordnete Rippen (34) auf der Reflexionswand (6, 7).

3. Vorrichtung nach einem der vorhergehenden Ansprüche, **dadurch gekennzeichnet, daß** die Rippen (34) durch Nuten (32) gebildet werden.

4. Vorrichtung nach einem der vorhergehenden Ansprüche, **dadurch gekennzeichnet, daß** die Heizquellen (25) Stablampen sind.

5. Vorrichtung nach einem der vorhergehenden Ansprüche, **dadurch gekennzeichnet, daß** der Winkel 45° beträgt.

6. Vorrichtung nach einem der vorhergehenden Ansprüche, **dadurch gekennzeichnet, daß** sich die Rippen (34) gleichmäßig über die ganze Reflexionswand (6, 7) hinweg erstrecken.

7. Vorrichtung nach einem der Ansprüche 1 bis 5, **dadurch gekennzeichnet, daß** sich die Rippen (34) wenigstens über Teilbereiche der Reflexionswand (6, 7) erstrecken.

8. Vorrichtung nach Anspruch 7, **dadurch gekennzeichnet, daß** sich die Rippen (34) in den Außenbereichen der Reflexionswand (6, 7) erstrecken.

9. Vorrichtung nach einem der vorhergehenden Ansprüche, **gekennzeichnet durch** eine Einrichtung zum Bewegen, insbesondere Drehen des zu erwärmenden Substrats im Strahlungsbereich der Reflexionswand.

10. Vorrichtung nach einem der vorhergehenden Ansprüche, **gekennzeichnet durch** eine Drehvorrichtung zum Drehen wenigstens einer wenigstens eine Rippe (34) aufweisenden Reflexionswand (6, 7).

11. Vorrichtung nach Anspruch 10, **gekennzeichnet durch** eine Steuereinheit zum Steuern der Drehvorrichtung.

## Claims

1. Device (1) for thermal treatment of substrates (2), with a reaction chamber (10), at least one elongate heat source (25) and at least one reflection wall (6, 7), which has at least one rib (34) and is adjacent to the heat source, for reflection of at least a part of a radiation radiated by the heat source (25), **characterised in that** the heat sources (25) are arranged at an angle obliquely relative to the longitudinal direction of the at least one rib (34).

2. Device according to claim 1, **characterised by** several ribs (34), which are arranged parallel to one another, on the reflection wall (6, 7).

3. Device according to one of the preceding claims, **characterised in that** the ribs (34) are formed by grooves (32).

4. Device according to one of the preceding claims, **characterised in that** the heat sources (25) are tubular lamps.

5. Device according to one of the preceding claims, **characterised in that** the angle amounts to 45°.

6. Device according to one of the preceding claims, **characterised in that** the ribs (34) extend uniformly away over the entire reflection wall (6, 7).

7. Device according to one of claims 1 to 5, **characterised in that** the ribs (34) extend at least over part regions of the reflection wall (6, 7).

8. Device according to claim 7, **characterised in that** the ribs (34) extend in the outer regions of the reflection wall (6, 7).

9. Device according to one of the preceding claims, **characterised by** equipment for moving, particularly rotating, the substrate, which is to be heated, in the radiation range of the reflection wall.

10. Device according to one of the preceding claims, **characterised by** a rotary device for rotating at least one reflection wall (6, 7) having at least one rib (34).

11. Device according to claim 10, **characterised by** a control unit for controlling the rotary device.

## Revendications

1. Dispositif (1) pour un traitement thermique de substrats (2), avec une chambre de réaction (10), au moins une source de chauffage oblongue (25) et au moins une paroi de réflexion (6, 7) présentant au moins une nervure (34), avoisinant la source de chauffage, pour la réflexion d'au moins une partie d'un rayonnement diffusé par la source de chauffage (25), **caractérisé en ce que** les sources de chauffage (25) sont disposées selon un angle oblique à la direction longitudinale d'au moins une nervure (34) précitée.

2. Dispositif selon la revendication 1, **caractérisé par** plusieurs nervures (34) disposées parallèlement les unes aux autres sur la paroi de réflexion (6, 7).

3. Dispositif selon l'une des revendications précédentes, **caractérisé en ce que** les nervures (34) sont formées par des rainures (32).

4. Dispositif selon l'une des revendications précédentes, **caractérisé en ce que** les sources de chauffage (25) sont des lampes tiges.

5. Dispositif selon l'une des revendications précédentes, **caractérisé en ce que** l'angle est de 45°.

6. Dispositif selon l'une des revendications précédentes, **caractérisé en ce que** les nervures (34) s'étendent régulièrement sur toute la paroi de réflexion (6, 7).

7. Dispositif selon l'une des revendications 1 à 5, **caractérisé en ce que** les nervures (34) s'étendent au moins sur des zones partielles de la paroi de réflexion (6, 7).

8. Dispositif selon la revendication 7, **caractérisé en ce que** les nervures (34) s'étendent dans les zones extérieures de la paroi de réflexion (6, 7).

9. Dispositif selon l'une des revendications précédentes, **caractérisé par** une installation pour le déplacement, notamment la rotation du substrat à chauffer dans la zone de rayonnement de la paroi de réflexion.

10. Dispositif selon l'une des revendications précédentes, **caractérisé par** un dispositif de rotation pour faire tourner au moins une paroi de réflexion (6, 7) présentant au moins une nervure (34).

11. Dispositif selon la revendication 10, **caractérisé par** une unité de commande pour la commande du dispositif de rotation.
